# EUROPEAN PATENT SPECIFICATION

(11) **EP 2 145 731 B1**
(45) Date of publication and mention of the grant of the patent: **29.02.2012**
(21) Application number: 09154937.8
(22) Date of filing: 11.03.2009
(51) Int. Cl.: B24B 37/04, B24D 13/14

(54) **A chemical mechanical polishing pad manufacturing assembly**
Herstellungsanordnung für ein chemisch-mechanisches Polierkissen
Ensemble de fabrication de tampon à polir mécanique et chimique

(30) Priority: 18.07.2008 US 175965
(43) Date of publication of application: 20.01.2010
(73) Proprietor: Rohm and Haas Electronic Materials CMP Holdings, Inc., Newark, DE 19713 (US)
(72) Inventor: Jensen, Michelle, Newark, DE 19702 (US); Nowland, John Gifford, Elkton, MD 21921 (US); Harding, Brenda, Newark, DE 19702 (US); Corder, Carol, Elk Mills, MD 21920 (US)
(74) Representative: Kent, Venetia Katherine

(56) References cited:
- US-A- 6 007 407
- US-A1- 2005 070 216
- US-A1- 2006 135 051

## Description

The present invention relates generally to the field of chemical mechanical polishing. In particular, the present invention is directed to a chemical mechanical polishing pad manufacturing assembly useful in the manufacture of chemical mechanical polishing pads.

In the fabrication of integrated circuits and other electronic devices, multiple layers of conducting; semiconducting and dielectric materials are deposited onto and removed from a surface of a semiconductor wafer. Thin layers of conducting, semiconducting and dielectric materials may be deposited using a number of deposition techniques. Common deposition techniques in modem wafer processing include physical vapor deposition (PVD), also known as sputtering, chemical vapor deposition (CVD), plasma-enhanced chemical vapor deposition (PECVD) and electrochemical plating, among others. Common removal techniques include wet and dry isotropic and anisotropic etching, among others.

As layers of materials are sequentially deposited and removed, the uppermost surface of the wafer becomes non-planar. Because subsequent semiconductor processing (e.g., metallization) requires the wafer to have a flat surface, the wafer needs to be planarized. Planarization is useful for removing undesired surface topography and surface defects, such as rough surfaces, agglomerated materials, crystal lattice damage, scratches and contaminated layers or materials.

Chemical mechanical planarization, or chemical mechanical polishing (CMP), is a common technique used to planarize or polish workpieces such as semiconductor wafers. In conventional CMP, a wafer carrier, or polishing head, is mounted on a carrier assembly. The polishing head holds the wafer and positions the wafer in contact with a polishing layer of a polishing pad that is mounted on a table or platen within a CMP apparatus. The carrier assembly provides a controllable pressure between the wafer and polishing pad. Simultaneously, a polishing medium is dispensed onto the polishing pad and is drawn into the gap between the wafer and polishing layer. To effect polishing, the polishing pad and wafer typically rotate relative to one another. As the polishing pad rotates beneath the wafer, the wafer sweeps out a typically annular shaped polishing track, or polishing region, wherein the wafer's surface directly confronts the polishing layer. The wafer surface is polished and made planar by chemical and mechanical action of the polishing layer and polishing medium on the surface.

Rutherford et al., in U.S. Patent No. 6,007,407, disclose multilayer, chemical mechanical polishing pads, wherein two layers of different materials are laminated together. The typical two-layer polishing pad includes an upper polishing layer formed of a material, such as, polyurethane suitable for polishing the surface of a substrate. The upper polishing layer is attached to a lower layer or "subpad" formed from a material suitable for supporting the polishing layer. Conventionally, the two layers are bonded together using a pressure sensitive adhesive. In some polishing applications, however, multilayer chemical mechanical polishing pads laminated together using pressure sensitive adhesives have a tendency to delaminate during polishing, rendering the polishing pad useless and impeding the polishing process.

One approach to alleviating the delamination problem is disclosed in United States Patent No. 7,101,275 to Roberts et al. Roberts et al. disclose resilient laminated polishing pads for chemical mechanical polishing, which pads include a base layer bonded to a polishing layer by a reactive hot melt adhesive rather than a pressure sensitive adhesive.

Notwithstanding, there is a continuing need for resilient multilayer laminated chemical mechanical polishing pads that resist internal breakdown (i.e., delamination) during use and for an improved chemical mechanical polishing pad assembly useful in the manufacture of such resilient multilayer laminated chemical mechanical polishing pads.
The invention is set out in the accompanying claims.

### BRIEF DESCRIPTION OF THE DRAWINGS

**Figure 1A** is a bottom plan view of a chemical mechanical polishing pad manufacturing assembly of the present invention.

**Figure 1B** is an elevation cut away view A-A of the chemical mechanical polishing pad manufacturing assembly of **Figure 1A****.**

**Figure 2** is a top plan view of a subpad layer designed to be incorporated into a chemical mechanical polishing pad manufacturing assembly as depicted in **Figures 1A** **and** **1B****.**

**Figure 3** is a top plan view of a sacrificial layer designed to be incorporated into a chemical mechanical polishing pad manufacturing assembly as depicted in **Figures 1A** **and** **1B****.**

**Figure 4** is a top plan view of a backing plate designed to be incorporated into a chemical mechanical polishing pad manufacturing assembly as depicted in **Figures 1A** **and** **1B****.**

**Figure 5A** is a top plan view of a chemical mechanical polishing pad manufacturing assembly having with an unset reactive hot melt adhesive applied to the top surface of the subpad layer.

**Figure 5B** is an elevational view of a cut away view B-B of the chemical mechanical polishing pad manufacturing assembly of **Figure 5A****.**

**Figure 6** is a perspective top/side view of a chemical mechanical polishing pad manufacturing assembly of the present invention.

### DETAILED DESCRIPTION

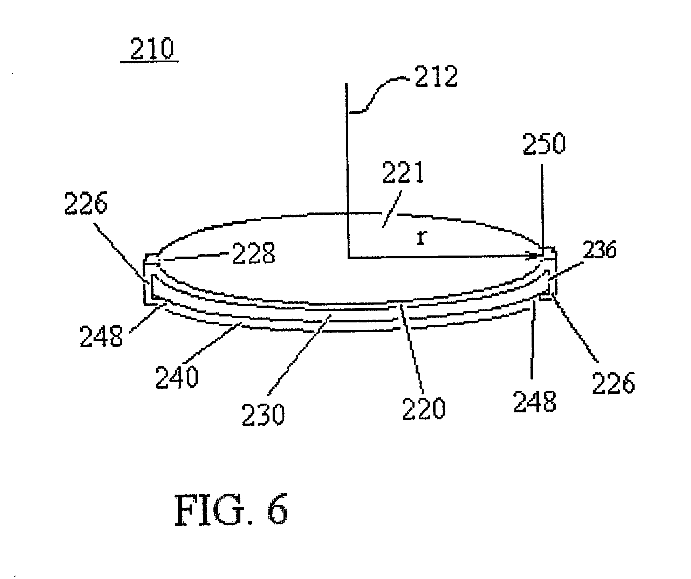

The term **"substantially circular cross section"** as used herein and in the appended claims in reference to a chemical mechanical polishing pad manufacturing assembly or component thereof means that the longest radius, r, of a cross section from a central axis to an outer periphery of the chemical mechanical polishing pad manufacturing assembly or component thereof is ≤20% longer than the shortest radius, r, of the cross section from the central axis to the outer periphery. (See **Figure 6**).

In some embodiments of the present invention, there is provided a chemical mechanical polishing pad manufacturing assembly, wherein the chemical mechanical polishing pad manufacturing assembly exhibits a substantially circular cross section.

In some embodiments of the present invention, there is provided a chemical mechanical polishing pad manufacturing assembly, comprising a pressure sensitive adhesive interposed between the at least two wrap around tabs and the bottom side of the backing plate, wherein the pressure sensitive adhesive secures the at least two wrap around tabs to the backing plate. In some aspects of these embodiments, the subpad layer is perforated to facilitate removal of the at least two wrap around tabs.

In some embodiments of the present invention, there is provided a chemical mechanical polishing pad manufacturing assembly comprising: a subpad layer having a top surface, a bottom surface and at least two wrap around tabs; a backing plate having a top side and a bottom side; a pressure sensitive adhesive applied to the bottom surface of the subpad layer; a release liner applied over the pressure sensitive adhesive such that the pressure sensitive adhesive is interposed between the bottom surface of the subpad layer and the release liner; a sacrificial layer having at least two recessed areas designed to facilitate attachment of the subpad layer to the backing plate; wherein the subpad layer is disposed on the top side of the backing plate and the sacrificial layer is disposed on the bottom side of the backing plate, and wherein the at least two wrap around tabs extend to the bottom side of the backing plate. In some aspects of these embodiments, the release liner is removed or is absent from the at least two wrap around tabs. In some aspects of these embodiments, the pressure sensitive adhesive applied to the at least two wrap around tabs makes adhesive contact with the at least two wrap around tabs and the bottom side of the backing plate. In some aspects of these embodiments, the pressure sensitive adhesive secures the at least two wrap around tabs to the bottom side of the backing plate and thereby holds the subpad layer to the backing plate. In some aspects of these embodiments, the subpad layer is perforated to facilitate removal of the at least two wrap around tabs.

In some embodiments of the present invention, the subpad layer further comprises at least one opening. In some aspects of these embodiments, the at least one opening facilitates the manufacture of a chemical mechanical polishing pad having a window to enable *in situ* monitoring of a chemical mechanical polishing operation. In some aspects of these embodiments, the at least one opening has a cross section selected from a circular cross section, an elliptical cross section and a squoval cross section. In some aspects of these embodiments, the at least one opening has a circular cross section. In some aspects of these embodiments, the at least one opening has an elliptical cross section. In some aspects of these embodiments, the at least one opening has a squoval cross section.

In some embodiments of the present invention, the subpad layer comprises any material suitable for use in a chemical mechanical polishing pad. In some aspects of these embodiments, the subpad layer comprises an elastic polymeric material. In some aspects of these embodiments, the subpad layer comprises a material selected from a polyurethane impregnated felt and a polyurethane foam. In some aspects of these embodiments, the subpad layer is a polyurethane impregnated felt. In some aspects of these embodiments, the subpad layer is a polyurethane foam. In some aspects of these embodiments, the subpad layer is a buffed high density urethane foam. In some aspects of these embodiments, the subpad layer is a closed cell polyurethane foam.

One of ordinary skill in the art would understand to select a subpad layer having a thickness suitable to provide the desired mechanical properties to a given multilayer chemical mechanical polishing pad for use in a given polishing operation. In some embodiments of the present invention, the subpad layer has a thickness of 0.75 to 2.5 mm; preferably 0.75 to 2.0 mm.

In some embodiments of the present invention, there is provided a chemical mechanical polishing pad manufacturing assembly comprising: a subpad layer having a top surface, a bottom surface and at least two wrap around tabs; an unset reactive hot melt adhesive applied to the top surface of the subpad layer; a backing plate having a top side and a bottom side; a sacrificial layer having at least two recessed areas designed to facilitate attachment of the subpad layer to the backing plate; wherein the subpad layer is disposed on the top side of the backing plate and the sacrificial layer is disposed on the bottom side of the backing plate; wherein the at least two wrap around tabs extend to the bottom side of the backing plate; and, wherein the unset reactive hot melt adhesive is applied in a pattern of parallel lines. In some aspects of these embodiments, the subpad layer is perforated to facilitate removal of the at least two wrap around tabs. In some aspects of these embodiments, the unset reactive hot melt adhesive is applied to the top surface of the subpad layer at a coat weight of 6,500 to 13,940 g/cm², preferably 8,350 to 12,100 g/cm². In some aspects of these embodiments, the pattern of parallel lines contains a plurality of individual lines, wherein the individual lines are parallel to one another. In some aspects of these embodiments, the individual lines exhibit a thickness of 0.05 to 0.20 mm, preferably 0.0762 to 0.172 mm; a width of 1.5 to 3.25 mm, preferably 1.58 to 3.18 mm; and a spacing between individual lines in the pattern of parallel lines of 1.5 to 3.25 mm, preferably 1.58 to 3.18 mm. In some aspects of these embodiments, there are valleys between the individual lines that are devoid of unset reactive hot melt adhesive. In some aspects of these embodiments, there are valleys between the individual lines that are not devoid of unset reactive hot melt adhesive, wherein the thickness of the unset reactive hot melt adhesive measured at the center of the valleys is ≤5% of the thickness of the unset reactive hot melt adhesive measured at the center of the individual lines. In some aspects of these embodiments, the unset reactive hot melt adhesive exhibits a melting temperature of 50 to 150 °C, preferably of 115 to 135°C and a pot life of ≤ 90 minutes after melting. In some aspects of these embodiments, the unset reactive hot melt adhesive in its uncured state comprises a polyurethane resin (e.g., Mor-Melt™ R5003 available from Rohm and Haas).

In one aspect of the present invention, there is provided a chemical mechanical polishing pad manufacturing assembly comprising: a subpad layer having a top surface, a bottom surface and at least two wrap around tabs; a backing plate having a top side and a bottom side; a sacrificial layer having at least two recessed areas designed to facilitate attachment of the subpad layer to the backing plate; and a layer of pressure sensitive adhesive interposed between the sacrificial layer and the bottom side of the backing plate; wherein the subpad layer is disposed on the top side of the backing plate; wherein the layer of pressure sensitive adhesive secures the sacrificial layer to the bottom side of the backing plate and wherein the at least two wrap around tabs extend to the bottom side of the backing plate. In some aspects of these embodiments, the subpad layer is perforated to facilitate removal of the at least two wrap around tabs.

In one aspect of the present invention, there is provided a chemical mechanical polishing pad manufacturing assembly comprising: a subpad layer having a top surface, a bottom surface and at least two wrap around tabs; a backing plate having a top side and a bottom side; a sacrificial layer having at least two recessed areas designed to facilitate attachment of the subpad layer to the backing plate; wherein the subpad layer is disposed on the top side of the backing plate and the sacrificial layer is disposed on the bottom side of the backing plate; wherein the at least two wrap around tabs extend to the bottom side of the backing plate and wherein the at least two wrap around tabs engage the at least two recessed areas of the sacrificial layer. In some aspects of these embodiments, the at least two wrap around tabs do not make physical contact with the sacrificial layer. In some aspects of these embodiments, the at least two wrap around tabs interlock with the at least two recessed areas of the sacrificial layer. In some aspects of these embodiments, the interlocking engagement of the at least two wrap around tabs with the at least two recessed areas of the sacrificial layer secures the subpad layer to the backing plate. In some aspects of these embodiments, the subpad layer is perforated to facilitate removal of the at least two wrap around tabs.

In practicing the invention, given the teachings provided herein, one or ordinary skill in the art would understand to select a backing plate having a suitable thickness and material of construction. In some embodiments of the present invention, the backing plate has a thickness of 2.54 to 5.1 mm. In some aspects of these embodiments, the backing plate is constructed of a material selected from aluminum and acrylic sheet.

In some embodiments of the present invention, the backing plate has a substantially circular cross section. One of ordinary skill in the art will understand that the diameter of the backing plate is limited by the size of the coater used to apply the unset reactive hot melt adhesive. In some aspects of these embodiments, the backing plate exhibits a diameter of 600 to 1,600 mm; preferably 600 to 1,200 mm.

In some embodiments of the present invention, there is provided a chemical mechanical polishing pad manufacturing assembly comprising: a subpad layer having a top surface, a bottom surface and at least two wrap around tabs; a backing plate having a top side and a bottom side; a sacrificial layer having at least two recessed areas designed to facilitate attachment of the subpad layer to the backing plate; an unset reactive hot melt adhesive applied to the top surface of the subpad layer in a pattern of parallel lines; a first pressure sensitive adhesive applied to the bottom surface of the subpad layer; a release liner, wherein the first pressure sensitive adhesive is interposed between the bottom surface of the subpad layer and the release liner, and wherein the release liner is absent from the at least two wrap around tabs exposing the first pressure sensitive adhesive applied to the at least two wrap around tabs to the backing plate; and, a second pressure sensitive adhesive interposed between the sacrificial layer and the bottom side of the backing plate, wherein the second pressure sensitive adhesive is compositionally the same or different from the first pressure sensitive adhesive; wherein the subpad layer is disposed on the top side of the backing plate; wherein the at least two wrap around tabs extend to the bottom side of the backing plate; wherein the first pressure sensitive adhesive applied to the at least two wrap around tabs and exposed to the backing plate secures the at least two wrap around tabs to the bottom side of the backing plate; and, wherein the second pressure sensitive adhesive secures the sacrificial layer to the bottom side of the backing plate. In some aspects of these embodiments, the subpad layer is perforated to facilitate removal of the at least two wrap around tabs.

The present invention will now be described in further detail herein in reference to the **Figures.** The chemical mechanical polishing pad manufacturing assembly as described and shown in the **Figures** has a substantially circular cross section. Notwithstanding, given the teachings provided herein, one of ordinary skill in the art would understand how to employ other geometric cross sections such as, for example, polygonal, annular, oval and amorphous.

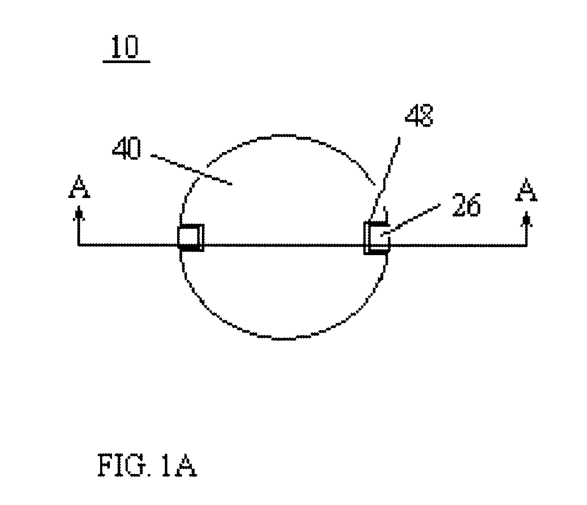

In **Figure 1A** there is provided a bottom plan view of a chemical mechanical polishing pad manufacturing assembly of the present invention. In particular, **Figure 1A** provides a view of a sacrificial layer **40** with recessed portions **48.** **Figure 1A** also provides a view of wrap around tabs **26** of a subpad layer **20** engaged with recessed areas **48** of the sacrificial layer **40.**

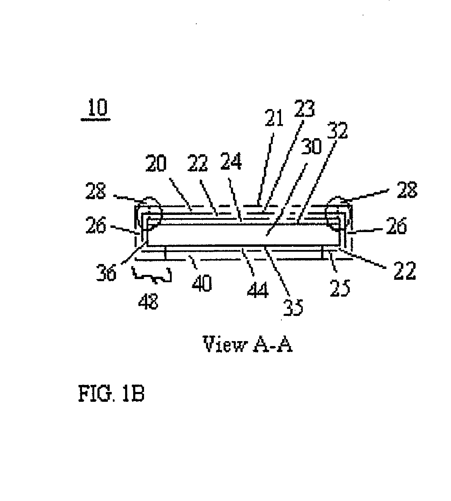

In **Figure 1B** there is provided a side elevational cut away view A-A of the chemical mechanical polishing pad manufacturing assembly of **Figure 1A****.** In particular, **Figure 1B** provides a view of subpad layer **20** having a top surface **21** and a bottom surface **23** with wrap around tabs **26** having perorations **28,** which perforations **28** facilitate removal of the wrap around tabs **26** from the subpad layer **20.** A first pressure sensitive adhesive **22** is applied to a bottom surface **23** of the subpad layer **20.** The first pressure sensitive adhesive **22** is interposed between the bottom surface **23** of the subpad layer **20** and a release liner **24,** which is interposed between the first pressure sensitive adhesive **22** and a top side **32** of the backing plate **30.** A sacrificial layer **40** is adhered to the bottom side **35** of the backing plate **30** with a second pressure sensitive adhesive layer **44.** The sacrificial layer **40** has recessed areas **48.** The release liner **24** is absent from the first pressure sensitive adhesive **22** applied to a bottom surface **25** of the wrap around tabs **26,** such that the first pressure sensitive adhesive **22** makes adhesive contact between the wrap around tabs **26** and a bottom side **35** of backing plate **30.** The wrap around tabs **26** extend around the outer periphery **36** of backing plate **30** and engage the recessed areas **48** in the sacrificial layer **40.**

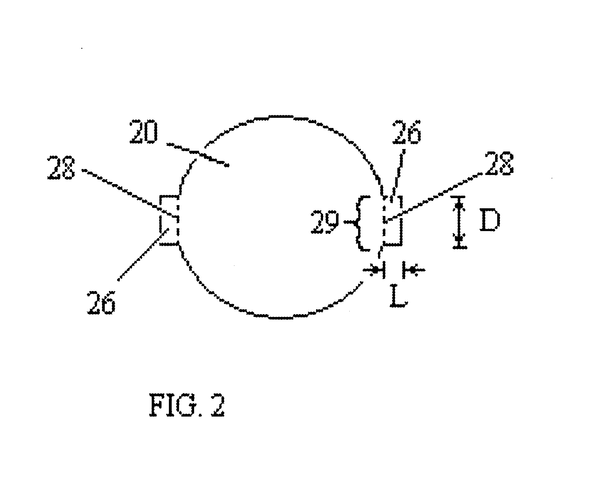

In **Figure 2** there is provided a top plan view of the subpad layer **20** of the chemical mechanical polishing pad manufacturing assembly shown in **Figures 1A** and **1B****.** In particular, **Figure 2** shows a top plan view of the subpad layer **20** with perforations **28** and wrap around tabs **26.** In some embodiments of the present invention, the wrap around tabs **26** of the subpad layer **20** extend a length, **L,** 10 to 50 mm from the perforation **28** of the subpad layer and extend a distance, **D,** 50 to 200 mm, preferably 50 to 100 mm, along the perforation **29** of the subpad layer.

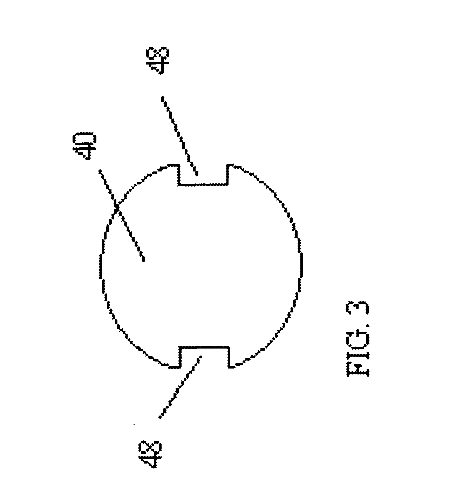

In **Figure 3** there is provided a top plan view of the sacrificial layer **40** of the chemical mechanical polishing pad manufacturing assembly shown in **Figures 1A** and **1B****.** In particular, **Figure 3** shows a top plan view of the sacrificial layer **40** with recessed portions **48** designed to engage with the wrap around tabs **28** of the subpad layer **20** as shown in **Figure 2****.**

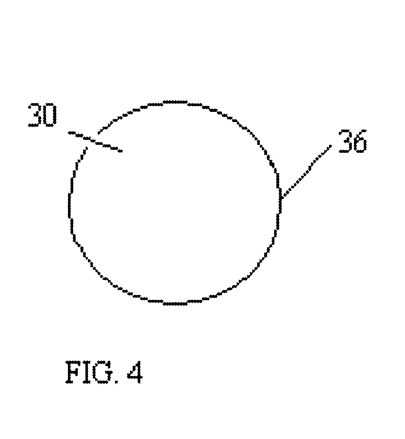

In **Figure 4** there is provided a top plan view of the backing plate **30** of the chemical mechanical polishing pad manufacturing assembly shown in **Figures 1A** and **1B****.** In particular, **Figure 4** shows a top plan view of the backing plate **30** having an outer periphery **36,** wherein the backing plate has a substantially circular cross section.

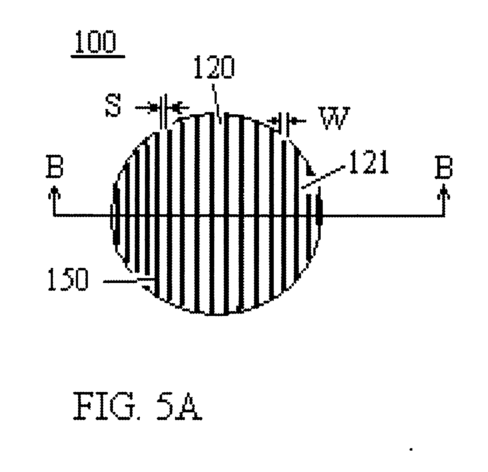

In **Figure 5A** there is provided a top plan view of a chemical mechanical polishing pad manufacturing assembly having an unset reactive hot melt adhesive applied to a top surface **121** of a subpad layer **120.** In particular, **Figure 5A** provides a view of a subpad layer **120** and a pattern of individual parallel lines of unset reactive hot melt adhesive **150** applied to a top surface **121** of the subpad layer **120.** The individual parallel lines of unset reactive hot melt adhesive in the pattern **150** have a width **W** and a separation S between adjacent lines.

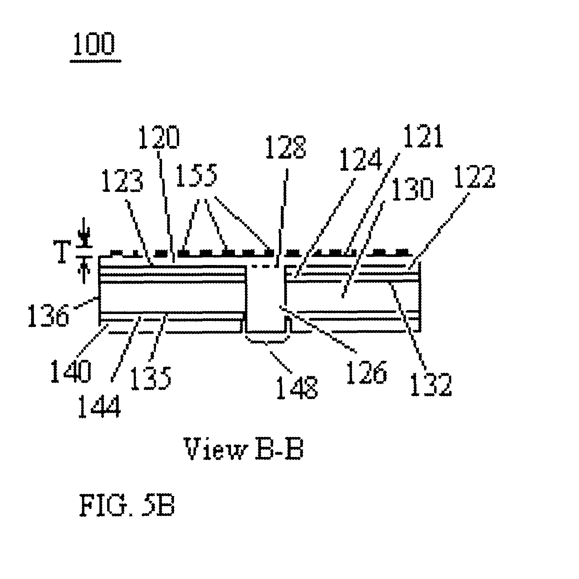

In **Figure 5B** there is provided a side elevation cut away view B-B of the chemical mechanical polishing pad manufacturing assembly depicted in **Figure 5A****.** In particular, **Figure 5B** provides a view of subpad layer **120** having a top surface **121** and a bottom surface **123** with wrap around tabs **126** having perforations **128,** which perforations **128** facilitate the subsequent removal of the wrap around tabs **126** from the subpad layer **120.** A first pressure sensitive adhesive **122** is applied to a bottom surface **123** of the subpad layer **120.** The first pressure sensitive adhesive **122** is interposed between the bottom surface **123** of the subpad layer **120** and a release liner **124,** which is interposed between the first pressure sensitive adhesive **122** and a top side **132** of the backing plate **130.** A sacrificial layer **140** is adhered to the bottom side **135** of the backing plate **130** with a second pressure sensitive adhesive **144.** The sacrificial layer **140** has recessed areas **148.** The release liner **124** is absent from the first pressure sensitive adhesive **122** applied to a bottom surface **125** of the wrap around tabs **126,** such that the first pressure sensitive adhesive **122** makes adhesive contact between the wrap around tabs **126** and a bottom side **135** of backing plate **130.** The perforated wrap around tabs **126** extend around an outer periphery **136** of backing plate **130** and engage the recessed areas **148** in the sacrificial layer **140.** In the particular embodiment of the present invention depicted in **Figure 5B****,** the chemical mechanical polishing pad manufacturing assembly has a pattern of individual parallel lines of unset reactive hot melt adhesive **155** applied to a top surface **121** of the subpad layer **120.** The individual parallel lines of unset reactive hot melt adhesive in the pattern **155** have a thickness **T.**

In **Figure 6** there is provided a top/side perspective view of a chemical mechanical polishing pad manufacturing assembly in accordance with some embodiments of the present invention. In particular, **Figure 6** provides a view of the top surface **221** of a subpad layer **220** of the chemical mechanical polishing pad manufacturing assembly **210** that is in a plane substantially perpendicular to a central axis **212** of the chemical mechanical polishing pad manufacturing assembly. In some aspects of these embodiments, the chemical mechanical polishing pad manufacturing assembly has a substantially circular cross section perpendicular to the central axis **212.** In some aspects of these embodiments, the longest radius, r, from the central axis **212** to an outer periphery **250** of a cross section of the chemical mechanical polishing pad manufacturing assembly **210** in a plane that is perpendicular to the central axis **212,** is ≤ 20%, preferably ≤ 10% longer than the shortest radius, r. In some aspects of these embodiments, the radius, r, of the cross section is 300 to 600 mm. In some aspects of these embodiments, the wrap around tabs **226** of the subpad layer **220** extend from the perforation **228** of the subpad layer and wrap around an outer periphery **236** of the backing plate **230** and engage recessed portions **248** of sacrificial layer **240.**

The chemical mechanical polishing pad manufacturing assembly of the present invention is useful in the manufacture of multilayer chemical mechanical polishing pads comprising a polishing layer, optionally one or more intermediate layers and a subpad layer.

In some embodiments of the present invention, the chemical mechanical polishing pad manufacturing assembly is incorporated into multilayer chemical mechanical polishing pads comprising a polishing layer made from a polymeric material comprising a polymer selected from polycarbonates, polysulfones, nylons, polyethers, polyesters, polystyrenes, acrylic polymers, polymethyl methacrylates, polyvinylchlorides, polyvinylfluorides, polyethylenes, polypropylenes, polybutadienes, polyethylene imines, polyurethanes, polyether sulfones, polyamides, polyether imides, polyketones, epoxies, silicones , EPDM, and combinations thereof. In some aspects of these embodiments, the polishing layer comprises a polyurethane.

One of ordinary skill in the art will understands to select a polishing layer having a thickness suitable for use in a given multilayer chemical mechanical polishing pad for a given polishing operation. In some embodiments of the present invention, the chemical mechanical polishing pad manufacturing assembly is incorporated into multilayer chemical mechanical polishing pads comprising a polishing layer exhibiting an average thickness of 20 to 150 mils. In some aspects of these embodiments, the polishing layer has an average thickness of 30 to 125 mils. In some aspects of these embodiments, the polishing layer has an average thickness of 40 to 120 mils.

In some embodiments of the present invention, there is provided a method of manufacturing a multilayer chemical mechanical polishing pad, comprising: providing a polishing layer; providing a chemical mechanical polishing pad manufacturing assembly, comprising: a subpad layer having a top surface, a bottom surface and at least two wrap around tabs; a backing plate having a top side and a bottom side; a sacrificial layer having at least two recessed areas designed to facilitate attachment of the subpad layer to the backing plate; an unset reactive hot melt adhesive applied to the top surface of the subpad layer in a pattern of parallel lines; wherein the subpad layer is disposed on the top side of the backing plate and the sacrificial layer is disposed on the bottom side of the backing plate, and wherein the at least two wrap around tabs extend to the bottom side of the backing plate; stacking the polishing layer and the chemical mechanical polishing pad manufacturing assembly with the unset reactive hot melt adhesive interposed between the polishing layer and the subpad layer forming a stack; applying an axial force to the stack; allowing the unset reactive hot melt adhesive to set forming a reactive hot melt adhesive bond between the subpad layer and the polishing layer; separating the at least two wrap around tabs from the subpad layer; and, removing the subpad layer with the polishing layer attached thereto from the chemical mechanical polishing pad manufacturing assembly providing a multilayer chemical mechanical polishing pad. In some aspects of these embodiments, the at least two wrap around tabs are cut from the subpad layer. In some aspects of these embodiments, a die is used to stamp/cut the stack to provide the multilayer chemical mechanical polishing pad comprising the subpad layer bonded to the polishing layer. In some aspects of these embodiments, the subpad layer is perforated to facilitate removal of the at least two wrap around tabs.

## Claims

1. A chemical mechanical polishing pad manufacturing assembly (10; 100; 210) for use in the manufacture of multilayer chemical mechanical polishing pads comprising a polishing layer, optionally one or more intermediate layers and a sub-pad layer (20; 120; 220), comprising:
the subpad layer (20; 120; 220) having a top surface (21; 121; 221), a bottom surface (23; 123) and at least two wrap around tabs (26; 126; 226);
a backing plate (30; 130; 230) having a top side (32; 132) and a bottom side (35; 135); and,
a sacrificial layer (40; 140; 240) having at least two recessed areas (48; 148; 248) designed to facilitate attachment of the subpad layer (20; 120; 220) to the backing plate (30; 130; 230);
wherein the subpad layer (20; 120; 220) is disposed on the top side (32; 132) of the backing plate (30; 130; 230) and the sacrificial layer (40; 140; 240) is disposed on the bottom side (35; 135) of the backing plate (30; 130; 230), and wherein the at least two wrap around tabs (26; 126; 226) extend to the bottom side (35; 135) of the backing plate (30; 130; 230) into respective recessed areas (48; 148; 248) of the sacrificial layer (40; 140; 240).

2. The chemical mechanical polishing pad manufacturing assembly (100) of claim 1, further comprising:
an unset reactive hot melt adhesive 155 applied to the top surface (121) of the subpad layer (120);
wherein the unset reactive hot melt adhesive (155) is applied in a pattern of parallel lines (150).

3. The chemical mechanical polishing pad manufacturing assembly (10; 100; 210) of claim 1, wherein the subpad layer (20; 120; 220) has perforations (28; 128; 228) to facilitate removal of the at least two wrap around tabs (26; 126; 226).

4. The chemical mechanical polishing pad manufacturing assembly (10; 100) of claim 1, further comprising a pressure sensitive adhesive (22; 122) interposed between a bottom surface (25; 125) of the at least two wrap around tabs (26; 126) and the bottom side (35; 135) of the backing plate (30; 130), wherein the pressure sensitive adhesive (22; 122) secures the at least two wrap around tabs (26; 126) to the bottom side (35; 135) of the backing plate (30; 130).

5. The chemical mechanical polishing pad manufacturing assembly (10; 100) of claim 1, further comprising a pressure sensitive adhesive (22; 122) applied to the bottom surface (23; 123) of the subpad layer (20; 120) and a release liner (24; 224), wherein the release liner (24; 124) is interposed between the pressure sensitive adhesive (22; 122) and the top side (32; 132) of the backing plate (30; 130), and wherein the release liner (24; 124) is absent from the at least two wrap around tabs (26; 126) such that the pressure sensitive adhesive (22; 122) applied to the bottom surface (23; 123) of the subpad layer (20; 120) secures the at least two wrap around tabs (26; 126) to the bottom side (35; 135) of the baking plate (30; 130).

6. The chemical mechanical polishing pad manufacturing assembly (10; 100) of claim 1, further comprising a layer of pressure sensitive adhesive (44; 144) interposed between the sacrificial layer (40; 140) and the bottom side (35; 135) of the backing plate (30; 130), wherein the pressure sensitive adhesive (44; 144) secures the sacrificial layer (40; 140) to the bottom side (35; 135) of the backing plate (30; 130).

7. The chemical mechanical polishing pad manufacturing assembly (10; 100; 210) of claim 1, wherein the at least two wrap around tabs (26; 126; 226) engage the at least two recessed areas (48; 148; 248) of the sacrificial layer (40; 140; 240).

8. The chemical mechanical polishing pad manufacturing assembly (10; 100; 210) of claim 1, wherein the at least two wrap around tabs (26; 126; 226) interlock with the at least two recessed areas (48; 148; 248) of the sacrificial layer (40; 140; 240).

9. The chemical mechanical polishing pad manufacturing assembly (100) of claim 1, further comprising:
an unset reactive hot melt adhesive (155) applied to the top surface of the subpad layer in a pattern of parallel lines (150);
a first pressure sensitive adhesive (122) applied to the bottom surface (123) ofthe subpad layer (120);
a release liner (124), wherein the first pressure sensitive adhesive (122) is interposed between the bottom surface (123) of the subpad layer (120) and the release liner (124), wherein the release liner (124) is interposed between the first pressure sensitive adhesive (122) and the top side (132) of the backing plate (130) and wherein the release liner (124) is absent from the at least two wrap around tabs (126) exposing the first pressure sensitive adhesive (122) to the bottom side (135) of the backing plate (130); and,
a second pressure sensitive adhesive (144) interposed between the sacrificial layer (140) and the bottom side (135) ofthe backing plate (130), wherein the second pressure sensitive adhesive (144) is compositionally the same or different from the first pressure sensitive adhesive (122);
wherein the first pressure sensitive adhesive (122) exposed to the bottom side (135) ofthe backing plate (130) by way ofthe at least two wrap around tabs (126) secures the at least two wrap around tabs (126) to the bottom side (135) ofthe backing plate (130); and, wherein the second pressure sensitive adhesive (144) secures the sacrificial layer (140) to the bottom side (135) of the backing plate (130); and, wherein the at least two wrap around tabs (126) are perforated wrap around tabs.

10. A method of manufacturing a chemical mechanical polishing pad, comprising:
providing a polishing layer;
providing a chemical mechanical polishing pad manufacturing assembly (100), comprising:
a subpad layer (120) having a top surface (121), a bottom surface (123) and at least two wrap around tabs (126); a backing plate (130) having a top side (132) and a bottom side (135); a sacrificial layer (140) having at least two recessed areas (148) designed to facilitate attachment of the subpad layer (120) to the backing plate (130); an unset reactive hot melt adhesive (155) applied to the top surface (121) ofthe subpad layer (120), wherein the unset reactive hot melt adhesive (155) is applied in a pattern of parallel lines (150); wherein the subpad layer (120) is disposed on the top side (132) of the backing plate (130) and the sacrificial layer (140) is disposed on the bottom side (135) of the backing plate (130), and wherein the at least two wrap around tabs (126) extend to the bottom side (135) of the backing plate (130) into respective recessed areas (148) of the sacrificial layer (140);
stacking the polishing layer and the chemical mechanical polishing pad manufacturing assembly (100) with the unset reactive hot melt adhesive (155) interposed between the polishing layer and the subpad layer (120) forming a stack;
applying an axial force to the stack;
allowing the unset reactive hot melt adhesive (155) to set forming a reactive hot melt adhesive bond between the subpad layer (120) and the polishing layer;
separating the at least two wrap around tabs (126) from the subpad layer (120); and,
removing the subpad layer (120) with the polishing layer bonded thereto from the backing plate (130).

## Patentansprüche

1. Herstellungszusammenbau (10; 100; 210) für ein chemisch-mechanisches Polierkissen zur Verwerdung bei der Herstellung von mehrschichtigen chemischmechanischen Polierkissen, umfassend eine Polierschicht, gegebenenfalls eine oder mehrere Zwischenschichten und eine Unterkissenschicht (20; 120; 220), umfassend:
eine Unterkissenschicht (20; 120; 220), die eine obere Oberfläche (21; 121; 221), eine untere Oberfläche (23; 123) und mindestens zwei umspannende Laschen (26; 126; 226) aufweist;
eine Trägerplatte (30; 130; 230), die eine obere Seite (32; 132) und eine untere Seite (35; 135) aufweist; und,
eine Opferschicht (40; 140; 240), die mindestens zwei ausgesparte Bereiche (48; 148; 248) aufweist, die gestaltet sind, um die Befestigung der Unterkissenschicht (20; 120; 220) an die Trägerplatte (30; 130; 230) zu erleichtern;
wobei die Unterkissenschicht (20; 120; 220) an der oberen Seite (32; 132) der Trägerplatte (30; 130; 230) angebracht ist und die Opferschicht (40; 140; 240) an der unteren Seite (35, 135) der Trägerplatte (30; 130; 230) angebracht ist und wobei die mindestens zwei umspannenden Laschen (26; 126; 226) bis zur unteren Seite (35; 135) der Trägerplatte (30; 130; 230) in die jeweiligen ausgesparten Bereiche (48; 148; 248) der Opferschicht (40; 140; 240) reichen.

2. Herstellungszusammenbau (100) für ein chemisch-mechanisches Polierkissen gemäß Anspruch 1, weiter umfassend:
einen unausgehärteten reaktiven Heißschmelzklebstoff (155), der auf die obere Oberfläche (121) der Unterkissenschicht (120) aufgetragen ist;
wobei der unausgehärtete reaktive Heißschmelzklebstoff (155) gemäß einem Muster von parallelen Linien (150) aufgetragen ist.

3. Herstellungszusammenbau (10; 100; 210) für ein chemisch-mechanisches Polierkissen gemäß Anspruch 1, wobei die Unterkissenschicht (20; 120; 220) Perforationen (28; 128; 228) aufweist, um das Entfernen der mindestens zwei umspannenden Laschen (26; 126; 226) zu erleichtern.

4. Herstellungszusammenbau (10; 100) für ein chemisch-mechanisches Polierkissen gemäß Anspruch 1, weiter umfassend einen druckempfindlichen Klebstoff (22; 122), der zwischen eine untere Oberfläche (25; 125) der mindestens zwei umspannenden Laschen (26; 126) und der unteren Seite (35; 135) der Trägerplatte (30; 130) angebracht ist, wobei der druckempfindliche Klebstoff (22; 122) die mindestens zwei umspannenden Laschen (26; 126) an der unteren Seite (35; 135) der Trägerplatte (30; 130) befestigt.

5. Herstellungszusammenbau (10; 100) für ein chemisch-mechanisches Polierkissen gemäß Anspruch 1, weiter umfassend einen druckempfindlichen Klebstoff (22; 122) der auf die untere Oberfläche (23; 123) der Unterkissenschicht (20; 120) aufgetragen ist, und eine Trennschicht (24; 124), wobei die Trennschicht (24; 124) zwischen dem druckempfindlichen Klebstoff (22; 122) und der oberen Seite (32; 132) der Trägerplatte (30; 130) angebracht ist, und wobei die Trennschicht (24; 124) bei den mindestens zwei umspannenden Laschen (26; 126) nicht vorhanden ist, so dass der druckempfindliche Klebstoff (22; 122), der auf die untere Oberfläche (23; 123) der Unterkissenschicht (20; 120) aufgetragen ist, die mindestens zwei umspannenden Laschen (26; 126) an der unteren Seite (35; 135) der Trägerplatte (30; 130) befestigt.

6. Herstellungszusammenbau (10; 100) für ein chemisch-mechanisches Polierkissen gemäß Anspruch 1, weiter umfassend eine Schicht eines druckempfindlichen Klebstoffs (44; 144), die zwischen der Opferschicht (40; 140) und der unteren Seite (35; 135) der Trägerplatte (30; 130) angebracht ist, wobei der druckempfindliche Klebstoff (44; 144) die Opferschicht (40; 140) an der unteren Seite (35; 135) der Trägerplatte (30; 130) befestigt.

7. Herstellungszusammenbau (10; 100; 210) für ein chemisch-mechanisches Polierkissen gemäß Anspruch 1, wobei die mindestens zwei umspannenden Laschen (26; 126; 226) in die mindestens zwei ausgesparten Bereiche (48; 148; 248) der Opferschicht (40; 140; 240) greifen.

8. Herstellungszusammenbau (10; 100; 210) für ein chemisch-mechanisches Polierkissen gemäß Anspruch 1, wobei die mindestens zwei umspannenden Laschen (26; 126; 226) mit den mindestens zwei ausgesparten Bereichen (48; 148; 248) der Opferschicht (40; 140; 240) verzahnt sind.

9. Herstellungszusammenbau (100) für ein chemisch-mechanisches Polierkissen gemäß Anspruch 1, weiter umfassend
einen unausgehärteten reaktiven Heißschmelzklebstoff (155), der gemäß einem Muster von parallelen Linien (150) auf die obere Oberfläche der Unterkissenschicht aufgetragen ist;
einen ersten druckempfindlichen Klebstoff (122), der auf die untere Oberfläche (123) der Unterkissenschicht (120) aufgetragen ist;
eine Trennschicht (124), wobei der erste druckempfindliche Klebstoff (122) zwischen der unteren Oberfläche (123) der Unterkissenschicht (120) und der Trennschicht (124) angebracht ist, wobei die Trennschicht (124) zwischen dem ersten druckempfindlichen Klebstoff (122) und der oberen Seite (132) der Trägerplatte (130) angebracht ist, und wobei die Trennschicht (124) bei den mindestens zwei umspannenden Laschen (126) nicht vorhanden ist und der erste druckempfindliche Klebstoff (122) mit der unteren Seite (135) der Trägerplatte (130) in Kontakt gebracht ist; und einen zweiten druckempfindlichen Klebstoff (144), der zwischen der Opferschicht (140) und der unteren Seite (135) der Trägerplatte (130) angebracht ist, wobei der zweite druckempfindliche Klebstoff (144) aus der gleichen oder einer anderen Zusammensetzung wie der erste druckempfindliche Klebstoff (122) ist;
wobei der erste druckempfindliche Klebstoff (122), der der unteren Seite (135) der Trägerplatte (130) ausgesetzt ist, durch die mindestens zwei umhüllenden Laschen (126) die mindestens zwei umhüllenden Laschen (126) an der unteren Seite (135) der Trägerplatte (130) befestigt; und wobei der zweite druckempfindliche Klebstoff (144) die Opferschicht (140) an der unteren Seite (135) der Trägerplatte (130) befestigt; und wobei die mindestens zwei umhüllenden Laschen (126) perforierte umhüllende Laschen sind.

10. Herstellungsverfahren für ein chemisch-mechanisches Polierkissen, umfassend:
das Bereitstellen einer Polierschicht;
das Bereitstellen eines Herstellungszusammenbaus (100) für ein chemisch-mechanisches Polierkissen, umfassend:
eine Unterkissenschicht (120) mit einer oberen Oberfläche (121), einer unteren Oberfläche (123) und mindestens zwei umhüllenden Laschen (126); eine Trägerplatte (130) mit einer oberen Seite (132) und einer unteren Seite (135); eine Opferschicht (140) mit mindestens zwei ausgesparten Bereichen (148), die gestaltet sind,
um die Befestigung der Unterkissenschicht (120) an der Trägerplatte (130) zu erleichtern; einen unausgehärteten reaktiven Heißschmelzklebstoff (155), der auf die obere Oberfläche (121) der Unterkissenschicht (120) aufgetragen wird, wobei der unausgehärtete reaktive Heißschmelzklebstoff (155) gemäß einem Muster von parallelen Linien (150) aufgetragen wird; wobei die Unterkissenschicht (120) an der oberen Seite (132) der Trägerplatte (130) angebracht ist und die Opferschicht (140) an der unteren Seite (135) der Trägerplatte (130) angebracht ist, und wobei die mindestens zwei umhüllenden Laschen (126) bis zur unteren Seite (135) der Trägerplatte (130) in die jeweiligen ausgesparten Bereiche (148) der Opferschicht (140) reichen;
das Stapeln der Polierschicht und des Herstellungszusammenbaus (100) für ein chemisch-mechanisches Polierkissen, wobei der unausgehärtete reaktive Heißschmelzklebstoff (155) zwischen der Polierschicht und der Unterkissenschicht (120), die einen Stapel bilden, angebracht ist;
das Anwenden einer axialen Kraft auf den Stapel;
das Aushärten lassen des unausgehärteten reaktiven Heißschmelzklebstoffes (155) unter Bindung einer Bindung aus reaktivem Heißschmelzklebstoff zwischen der Unterkissenschicht (120) und der Polierschicht;
das Trennen der mindestens zwei umhüllenden Laschen (126) von der Unterkissenschicht (120); und
das Entfernen der Unterkissenschicht (120) mit der daran gebundenen Polierschicht von der Trägerplatte (130).

## Revendications

1. Ensemble de fabrication de patin de polissage mécanique et chimique (10 ;100 ;210) pour utilisation dans la fabrication de patins de polissage mécanique et chimique multicouches comportant une couche de polissage, éventuellement une ou plusieurs couches intermédiaires et une couche de sous-patin (20 ;120 ;220), comportant :
la couche de sous-patin (20 ; 120 ; 220) qui a une surface supérieure (21 ; 121 ; 221), une surface inférieure (23 ; 123) et au moins deux pattes d'enroulement (26 ; 126 ; 226) ;
une plaque de support (30 ; 130 ; 230) qui a un côté supérieur (32 ; 132) et un côté inférieur (35 ; 135) ; et,
une couche sacrificielle (40 ; 140 ; 240) qui a au moins deux zones renfoncées (48 ; 148 ; 248) conçues pour faciliter la fixation de la couche de sous-patin (20 ; 120 ; 220) sur la plaque de support (30 ; 130 ; 230) ;
la couche de sous-patin (20 ; 120 ; 220) étant disposée sur le côté supérieur (32 ; 132) de la plaque de support (30 ; 130 ; 230) et la couche sacrificielle (40 ; 140 ; 240) étant disposée sur le côté inférieur (35 ; 135) de la plaque de support (30 ; 130 ; 230), et les au moins deux pattes d'enroulement (26 ; 126 ; 226) s'étendant vers le côté inférieur (35 ; 135) de la plaque de support (30 ; 130 ; 230) dans des zones renfoncées respectives (48 ; 148 ; 248) de la couche sacrificielle (40 ; 140 ; 240).

2. Ensemble de fabrication de patin de polissage mécanique et chimique (100) selon la revendication 1, comportant en outre :
un adhésif thermo-fusible réactif non pris 155 appliqué sur la surface supérieure (121) de la couche de sous-patin (120) ;
l'adhésif thermo-fusible réactif non pris (155) étant appliqué suivant un dessin de lignes parallèles (150).

3. Ensemble de fabrication de patin de polissage mécanique et chimique (10 ;100 ;210) selon la revendication 1, dans lequel la couche de sous-patin (20 ;120 ;220) a des perforations (28 ;128 ;228) destinées à faciliter le retrait des au moins deux pattes d'enroulement (26 ; 126 ; ;226).

4. Ensemble de fabrication de patin de polissage mécanique et chimique (10 ;100) selon la revendication 1, comportant en outre un adhésif sensible à la pression (22 ;122) interposé entre une surface inférieure (25 ;125) des au moins deux pattes d'enroulement (26 ;126) et le côté inférieur (35 ;135) de la plaque de support (30 ;130), l'adhésif sensible à la pression (22 ;122) fixant les au moins deux pattes d'enroulement (26 ;126) sur le côté inférieur (35 ;135) de la plaque de support (30 ;130).

5. Ensemble de fabrication de patin de polissage mécanique et chimique (10 ;100) selon la revendication 1, comportant en outre un adhésif sensible à la pression (22 ;122) appliqué sur la surface inférieure (23 ;123) de la couche de sous-patin (20 ;120) et un revêtement de libération (24 ;224), le revêtement de libération (24 ;124) étant interposé entre l'adhésif sensible à la pression (22 ;122) et le côté supérieur (32 ;132) de la plaque de support (30 ;130), et le revêtement de libération (24 ;124) étant absent des au moins deux pattes d'enroulement (26 ;126) de telle sorte que l'adhésif sensible à la pression (22 ;122) appliqué sur la surface inférieure (23 ;123) de la couche de sous-patin (20 ;120) fixe les au moins deux pattes d'enroulement (26 ;126) sur le côté inférieur (35 ;135) de la plaque de support (30 ;130).

6. Ensemble de fabrication de patin de polissage mécanique et chimique (10 ;100) selon la revendication 1, comportant en outre une couche d'adhésif sensible à la pression (44 ;144) interposée entre la couche sacrificielle (40 ;140) et le côté inférieur (35 ;135) de la plaque de support (30 ;130), l'adhésif sensible à la pression (44 ;144) fixant la couche sacrificielle (40 ;140) sur le côté inférieur (35 ;135) de la plaque de support (30 ;130).

7. Ensemble de fabrication de patin de polissage mécanique et chimique (10 ;100 ;210) selon la revendication 1, dans lequel les au moins deux pattes d'enroulement (26 ; 126 ; 226) engagent les au moins deux zones renfoncées (48 ;148 ;248) de la couche sacrificielle (40 ;140 ;240).

8. Ensemble de fabrication de patin de polissage mécanique et chimique (10 ;100 ;210) selon la revendication 1, dans lequel les au moins deux pattes d'enroulement (26 ;126 ; 226) se bloquent avec les au moins deux zones renfoncées (48 ;148 ;248) de la couche sacrificielle (40 ;140 ;240).

9. Ensemble de fabrication de patin de polissage mécanique et chimique (100) selon la revendication 1, comportant en outre :
un adhésif thermo-fusible réactif non pris (155) appliqué sur la surface supérieure de la couche de sous-patin suivant un dessin de lignes parallèles (150) ;
un premier adhésif sensible à la pression (122) appliqué sur la surface inférieure (123) de la couche de sous-patin (120) ;
un revêtement de libération (124), le premier adhésif sensible à la pression (122) étant interposé entre la surface inférieure (123) de la couche de sous-patin (120) et le revêtement de libération (124), le revêtement de libération (124) étant interposé entre le premier adhésif sensible à la pression (122) et le côté supérieur (132) de la plaque de support (130) et le revêtement de libération (124) étant absent des au moins deux pattes d'enroulement (126) en exposant le premier adhésif sensible à la pression (122) sur le côté inférieur (135) de la plaque de support (130) ; et
un deuxième adhésif sensible à la pression (144) interposé entre la couche sacrificielle (140) et le côté inférieur (135) de la plaque de support (130), le deuxième adhésif sensible à la pression (144) étant sur le plan de la composition le même ou différent du premier adhésif sensible à la pression (122) ;
le premier adhésif sensible à la pression (122) exposé sur le côté inférieur (135) de la plaque de support (130) par les au moins deux pattes d'enroulement (126) fixant les au moins deux pattes d'enroulement (126) sur le côté inférieur (135) de la plaque de support (130) ; et, le deuxième adhésif sensible à la pression (144) fixant la couche sacrificielle (140) sur le côté inférieur (135) de la plaque de support (130) ; et, les au moins deux pattes d'enroulement (126) étant des pattes d'enroulement perforées.

10. Procédé de fabrication d'un patin de polissage mécanique et chimique comportant le fait de :
prévoir une couche de polissage ;
prévoir un ensemble de fabrication de patin de polissage mécanique et chimique (100), comportant :
une couche de sous-patin (120) qui a une surface supérieure (121), une surface inférieure (123) et au moins deux pattes d'enroulement (126) ; une plaque de support (130) qui a un côté supérieur (132) et un côté inférieur (135) ; une couche sacrificielle (140) qui a au moins deux zones renfoncées (148) conçues pour faciliter la fixation de la couche de sous-patin (120) sur la plaque de support (130) ; un adhésif thermo-fusible réactif non pris (155) appliqué sur la surface supérieure (121) de la couche de sous-patin (120), l'adhésif thermo-fusible réactif non pris (155) étant appliqué suivant un dessin de lignes parallèles (150) ; la couche de sous-patin (120) étant disposée sur le côté supérieur (132) de la plaque de support (130) et la couche sacrificielle (140) étant disposée sur le côté inférieur (135) de la plaque de support (130), et les au moins deux pattes d'enroulement (126) s'étendant vers le côté inférieur (135) de la plaque de support (130) dans des zones renfoncées respectives (148) de la couche sacrificielle (140) ;
empiler la couche de polissage et l'ensemble de fabrication de patin de polissage mécanique et chimique (100) avec l'adhésif thermo-fusible réactif non pris (155) interposé entre la couche de polissage et la couche de sous-patin (120) en formant une pile ;
appliquer une force axiale sur la pile ;
permettre à l'adhésif thermo-fusible réactif non pris (155) de prendre en formant un collage par adhésif thermo-fusible réactif entre la couche de sous-patin (120) et la couche de polissage ;
séparer les au moins deux pattes d'enroulement (126) de la couche de sous-patin (120) ; et,
enlever la couche de sous-patin (120) avec la couche de polissage collée dessus de la plaque de support (130).
